(19) Europäisches Patentamt
European Patent Office
Office européen des brevets

(11) **EP 2 678 564 B1**

(12) # EUROPÄISCHE PATENTSCHRIFT

(45) Veröffentlichungstag und Bekanntmachung des Hinweises auf die Patenterteilung:
**29.04.2015  Patentblatt 2015/18**

(21) Anmeldenummer: **12708268.3**

(22) Anmeldetag: **21.02.2012**

(51) Int Cl.:
*F04C 2/08* (2006.01)          *F04C 2/10* (2006.01)
*F16H 55/08* (2006.01)        *F16H 61/00* (2006.01)

(86) Internationale Anmeldenummer:
**PCT/EP2012/052894**

(87) Internationale Veröffentlichungsnummer:
**WO 2012/113768 (30.08.2012 Gazette 2012/35)**

(54) **VERFAHREN ZUR ERZEUGUNG DER ZAHNFORM VON INNEN- UND AUSSENRING EINER ZAHNRINGMASCHINE SOWIE DAMIT ERZEUGTER ZAHNRING**

METHOD FOR PRODUCING THE TOOTH SHAPE OF THE INNER AND OUTER RING OF AN ANNULAR GEAR MACHINE AND TOOTHED RING PRODUCED BY MEANS OF SAID METHOD

PROCÉDÉ DE GÉNÉRATION DE LA FORME DE DENT DE LA ROUE DENTÉE INTÉRIEURE ET DE LA ROUE DENTÉE EXTÉRIEURE D'UNE MACHINE À ROUES DENTÉES, ET ROUE DENTÉE PRODUITE PAR CE PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.02.2011  DE 102011000880**

(43) Veröffentlichungstag der Anmeldung:
**01.01.2014  Patentblatt 2014/01**

(73) Patentinhaber: **Geräte- und Pumpenbau GmbH, Dr. Eugen Schmidt**
**98673 Merbelsrod (DE)**

(72) Erfinder: **BLECHSCHMIDT, Andreas**
**98544 Zella-Mehlis (DE)**

(74) Vertreter: **Engel, Christoph Klaus**
**Engel patentanwaltskanzlei**
**Marktplatz 6**
**98527 Suhl (DE)**

(56) Entgegenhaltungen:
**EP-A1- 1 462 653        EP-A2- 0 978 667**
**EP-A2- 1 340 913        DE-A1- 3 134 668**
**US-A- 5 030 072**

**Beschreibung**

Die vorliegende Erfindung betrifft ein Verfahren zur Erzeugung der Zahnformen sowohl des Innenrings als auch des Außenrings einer Zahnringmaschine (auch als Gerotor bezeichnet), insbesondere einer Zahnringpumpe. Außerdem betrifft die Erfindung einen Zahnring einer Zahnringmaschine, der eine solche Verzahnung aufweist.

Zahnringmaschinen (Gerotormaschinen) besitzen einen Innenring und einen Außenring, die jeweils mit regelmäßig am Umfang verteilten Zähnen und Zahnlücken versehen sind. Die Drehachsen des Innenrings und des Außenrings sind exzentrisch zueinander versetzt. Der Innenring besitzt üblicherweise genau einen Zahn weniger als Zahnlücken an der Innenverzahnung des Außenrings vorgesehen sind. Heutzutage werden Zahnringmaschinen häufig als Zahnringpumpen verwendet, beispielsweise in Fahrzeugen als Hauptpumpe des Verbrennungsmotors. Der durch Zahnlücken und Gehäusewände gebildete Verdrängungsraum ändert sich mit der Drehung der Zahnräder, so dass die Förderung der Hydraulikflüssigkeit bewirkt wird. Das Fördervolumen pro Umdrehung ist dabei konstant. Die Zähne des außen verzahnten Innenrings werden dabei üblicherweise nach diversen Bildungsvorschriften des Abrollverhaltens vom Außenring gebildet. Eine solche bekannte Bildungsvorschrift ist z.B. die Bewegung der Erzeugungskontur nach den Gesetzen von zykloidischen Rollkurven an einem festgelegten Teilkreis.

Auf das Förderverhalten, den Wirkungsgrad, die Laufruhe und den Verschleiß einer Zahnringmaschine haben die gewählten Geometrien erheblichen Einfluss. Bei der Konstruktion lassen sich insbesondere die Zahnformen, die Exzentrizität der Drehachsen der beiden Zahnringe und das zwischen einzelnen Zahnabschnitten verbleibende Spiel gestalten, ohne unmittelbare Abhängigkeit von den äußeren Bedingungen, die durch die angeschlossene Antriebseinheit vorgegeben werden.

Aus der US 3,709,055 sind Zahnprofile für Zahnräder bekannt, die kreisförmige Zahnköpfe und kreisförmige Zahnfußprofile aufweisen, welche über gerade Flanken miteinander verbunden sind. Aus dieser Patentschrift ist auch ein Verfahren bekannt, um derartige Zahnprofile zu erzeugen, die beispielsweise in Zahnringmaschinen verwendet werden können. Mit der dort vorgeschlagenen Methode gelingt es jedoch nicht oder allenfalls in sehr engen Grenzen, ein wesentliches Ziel einer Zahnringmaschine zu erreichen, nämlich im Bewegungsablauf zwischen den beiden Zahnringen jederzeit eine geometrisch geschlossene Förderzelle auszubilden. Letzteres ist von besonderer Bedeutung für den Wirkungsgrad der Zahnringpumpe und die erreichbaren Drücke.

In der US 2,960,884 sind ebenfalls Zahnringmaschinen und Möglichkeiten zur Bestimmung der Zahngeometrie beschrieben. Die angegebene Zahngenerierungsmethode ist schwerpunktmäßig geeignet, einen evolventenähnlichen Bewegungsablauf zwischen funktional gekoppelten Zahngeometrien zu erreichen. Das oben genannte Hauptziel einer Zahnringmaschine, nämlich die im Bewegungsablauf gleich bleibende Dichtheit der Förderzelle über den gesamten Drehwinkel, lässt sich mit dieser Methode nur eingeschränkt erreichen.

In der JP 10-205458 A ist ein Verfahren zur Bestimmung der Zahngeometrie einer Zahnringpumpe angegeben. Dazu wird der Zahn eines Außenrings durch gekoppelte Kreisbögen beschrieben, woraufhin die Innenringverzahnung erzeugt werden kann. Die Definition von besonderen Geometrien der Verzahnungen mit Hinterschnitten oder beispielsweise zur Absenkung der Hertzschen Pressung ist durch die Beschränkung auf die Beschreibung der Zahnform mittels definierter Anzahl Kreisbögen nicht oder nur sehr eingeschränkt möglich.

Aus der EP 1 340 913 B1 und der DE 102 08 408 A1 ist eine Zahnradmaschine bekannt, die als Zahnringpumpe Verwendung findet. Dabei ist es vorrangiges Ziel, die Geometrie der Zahnräder zu optimieren, um die Geräusche im Betrieb der Pumpe zu verringern. Die verwendeten Zahnköpfe und Zahnfüße besitzen dafür eine Geometrie, die durch Kurven zweiter oder höherer Ordnung beschrieben sind, wobei die Zahnfüße oder die Flanken der Zahnfüße von Kreisbögen gebildet werden. Für die Bestimmung der Profilkonturen der Verzahnungen wird vorgeschlagen, die Innenverzahnung des Außenrotors als Masterverzahnung vorzugeben. Die Zahnfußprofilkontur des Innenrotors wird aus der Zahnkopfprofilkontur der Innenverzahnung kinematisch nach dem Verzahnungsgesetz abgeleitet, während die Zahnkopfprofilkontur aus den Hüllschnitten der Zahnfußprofilkontur der Innenverzahnung erhalten wird. Die Stützstellen der die Zahnfüße der Außenverzahnung darstellenden Polygonzüge werden mit dem Verzahnungsgesetz ermittelt, während die Stützstellen der die Zahnköpfe der Außenverzahnung darstellenden Spline-Funktionen mit einer Hüllschnittmethode ermittelt werden. Untersuchungen haben jedoch gezeigt, dass die Zahnformen, die auf diese Weise erzeugt werden können, zu Beschränkungen bezüglich Wirkungsgrad und Strömungsbedingungen in der Zahnringmaschine führen. Ebenfalls nachteilig wirkt sich die starre Definition der Fußausrundung aus, die z.B. beschränkend für die Ausformung eines Schmutzaufnahmeraums wirkt.

Die US 5,030,072 zeigt ein Verfahren zum Entwurf der Zahnform einer Zahnringmaschine, bei welchem zunächst ein radialer Nockenabstand festgelegt wird, um anschließend einen Nockenradius iterativ zu verändern, bis ein Einzelpunktabstand und ein Doppelpunktabstand dem festgelegten Nockenabstand gleichen.

Die DE 30 26 222 A1 zeigt eine Zahnringpumpe, bei welcher die theoretische Zahnform des Ritzels durch Abwälzen des Ritzelwälzkreises auf dem Hohlradwälzkreis bestimmt ist. Dabei wird zum Entwurf der Zahnform des Ritzels von einer bestimmten Form der Verzahnung ausgegangen. Das Verfahren ist nur für diese besondere Zahnform anwendbar.

Die US 2,666,336 zeigt ein Verfahren zum Entwurf von Verzahnungen von Rotoiden, welche im Gegensatz zu Gerotoren (Zahnringmaschinen) andere Zahnverhältnisse aufweisen. Als Ausgangspunkt dienen ein äußerer Kreis mit dem Durchmesser A und ein Ritzel-Kreis mit dem Durchmesser B, aus denen sich die Exzentrizität E ergibt.

In dem Artikel "Design of deviatation-function based gerotors", Shih-Hsi Tong et. al., Mechanism and Machine Theory 44 (2009) 1595-1606, wird ein neuartiges Verfahren zur Erzeugung von Gerotorprofilen erläutert. Dieses Verfahren basiert auf der Verwendung von Abweichungsfunktionen, erfordert jedoch aufwendige Berechnungen und Konstruktionsschritte und kann insbesondere bei Hinterschnitten zu Dimensionierungsproblemen führen.

Die EP 1 462 653 A1 zeigt eine Innenzahnradpumpe mit einem inneren Rotor und mit einem äußeren Rotor. Der innere Rotor weist ein Zahnprofil mit einem durch eine Hypozykloide gebildeten Fußteil auf. Der innere Rotor und der äußere Rotor weisen eine Exzentrizität e zueinander auf, wobei der Zwischenrotorabstand den Maximalwert t annimmt. Der äußere Rotor hat ein Zahnprofil, welches ausgehend vom Zahnprofil des inneren Rotors bestimmt wird. Hierzu wird der innere Rotor um den Mittelpunkt des äußeren Rotors rotiert. Dabei rotiert der innere Rotor auf seiner Achse 1/n-mal (n = Anzahl der Zähne), während der Mittelpunkt des äußeren Rotors eine Umdrehung in der Umlaufbahn ausführt. Bei dieser Bewegung wird eine Hüllkurve durch das Zahnprofil des inneren Rotors beschrieben, welche als Zahnprofil des äußeren Rotors verwendet wird.

Eine Aufgabe der vorliegenden Erfindung besteht ausgehend vom Stand der Technik darin, ein Verfahren zur Erzeugung der Zahnformen von Innen- und Außenring einer Zahnringmaschine, insbesondere einer Zahnringpumpe anzugeben, welches einfach auszuführen ist, kein tieferes Wissen über mathematische Zusammenhänge voraussetzt und dem Konstrukteur einen großen Dimensionierungsspielraum bereitstellt, um unterschiedlichste Anforderungen an die zu erzeugende Zahnringmaschine erfüllen zu können. Dabei wird angestrebt, auf die bislang übliche Beschreibung der Zahnkonturen durch Zykloiden, Ellipsen, Evolventen, Kreisbögen oder ähnliche mathematisch einfach zu beschreibende Kurvensegmente verzichten zu können, da diese die möglichen Geometrien der Zahnformen beschränken. Gleichzeitig sollen die zu erzeugenden Zahnformen mit derzeit zur Verfügung stehenden technischen Hilfsmitteln, beispielsweise CAD- und CAM-Systemen ausreichend genau beschrieben werden können, um eine automatisierte Fertigung entsprechender Innen- und Außenringe mit vorhandenen Werkzeugmaschinen zu ermöglichen.

Die vorgenannte Aufgabe wird durch ein Verfahren gemäß dem beigefügten Anspruch 1 gelöst.

Die Erfindung beruht auf der grundlegenden Erkenntnis, dass sich die Zahnformen von Innen- und Außenring durch das Beschreiben bzw. Ausführen einer Relativbewegung zwischen den beiden Ringen erzeugen lassen, wenn einige wenige, einfach zu definierende Parameter bzw. Ausgangsbedingungen eingehalten werden. Für die Erzeugung der Zahnform wird daher eine Relativbewegung zwischen Innen- und Außenring ausgeführt bzw. mathematisch modelliert, unter Zuhilfenahme der Winkelbeziehung dieser Relativbewegung und einer vorbestimmten Exzentrizität zwischen den Drehachsen der Ringe und einem vorläufig definierten Entwurfsteilkreis am Außenring.

Grundsätzlich lässt sich das Verfahren ausgehend von der Startgeometrie des Außenrings ausführen. Soweit nachfolgend nichts anderes angegeben wird, beziehen sich die Erläuterungen auf ein Beispiel, bei welchem der Außenring als ein erster Zahnring betrachtet wird, dessen Startgeometrie gewählt wird. Eine Zähnezahl des Außenringes ist notwendigerweise als Bestandteil der Startgeometrie ebenfalls festzulegen. Diese notwendige Festlegung ist beeinflusst durch die Wahl der Exzentrizität und der Baugröße der Pumpe (Teilkreis). Die Zähnezahl des Außenrings lässt sich dabei auch aus der gewünschten Zähnezahl des Innenrings bestimmen (Zähnezahl des Innenrings + 1). Bestandteil der festzulegenden Startgeometrie ist auch der Teilkreisradius (des Außenrings), der üblicherweise als der Mittelwert zwischen dem Radius am Zahnkopf und demjenigen am Zahnfuß verstanden wird (Teilkreis = Abstand von Zahnmitte zu Zahnmitte auf dem Wälzkreis). Das Ausführen der die Zahnformkontur erzeugenden Bewegung erfolgt vorzugsweise rechnergestützt an einem CAD-Modell. Hierbei wird die vorläufige Erzeugungsgeometrie als Hüllkurve unter Einhaltung der nachfolgend noch erläuterten Bewegungsbedingung zur Erzeugung und Bewertung des Gegenzahnes (am zweiten Zahnring) schrittweise rotiert.

Darüber hinaus ist für die vorliegende Erfindung entscheidend, dass durch die mehrfache Wiederholung des zuvor genannten Bewegungsablaufs bei jeweils veränderten Startbedingungen eine schrittweise Optimierung der Zahnformen erreichbar ist. Dies geschieht beispielsweise im Rahmen eines iterativen Prozesses, um ein oder mehrere zuvor bestimmte Gütekriterien durch die jeweils erzeugte Zahnform zu erfüllen bzw. sich diesen Gütekriterien soweit als möglich anzunähern. Als Gütekriterien kommen alle denkbaren Anforderungen an die zu erzeugende Zahnringmaschine in Betracht, beispielsweise der Wirkungsgrad, das Fördervolumen, der maximal zu erreichende Druck, ein verbleibendes minimales Spaltmaß zwischen Innenring und Außenring oder auch eine festgelegte Formgebung in bestimmten Abschnitten der Zahngeometrie, wodurch sich beispielsweise das Geräuschverhalten der Zahnringmaschine wesentlich beeinflussen lässt.

Um das erfindungsgemäße Verfahren durchzuführen, wird in einem ersten Schritt eine Startgeometrie des Außenrings festgelegt, die diesen vollständig beschreibt. Dazu zählt neben der Zahnbreite und der Zähnezahl auch ein vorläufiger Teilkreis und der Teilkreisradius am Außenring. Im Falle der Realisierung des Verfahrens durch eine Software geschieht diese Festlegung unter Nutzung der in üblichen CAD-Programmen vorhandenen Funktionen. Bei der Festlegung der Startgeometrie kann der Fachmann von aus dem Stand der Technik bekannten Zahnringformen ausgehen oder in weiten Grenzen eine Zahnringform frei wählen, von der er sich für die Erreichung eines oder mehrerer speziell angestrebter Parameter (Gütekriterien) der zu dimensionierenden Zahnringmaschine gute Ergebnisse erwartet. Die Startgeometrie muss dabei lediglich sicherstellen, dass sich damit eine Zahnringmaschine grundsätzlich aufbauen lässt.

Darüber hinaus ist es für die auszuführende Optimierung der Zahnringformen erforderlich, dass zumindest ein Gütekriterium der Zahnringmaschine definiert wird, dessen Erfüllung ein Ziel bei der Gestaltung der Zahnringe bzw. der an diesen zu verwendenden Zahnformen darstellt. Ein mögliches aber nicht in jedem Fall notwendiges Gütekriterium wäre z.B. die durchgängige Konstanz des Zahnkopfspieles über dem Drehwinkel. Vorrangig ist das Kopfspielverhalten im Bereich der maximalen Annäherung von Kopfkreis am Innenring und Fußkreis am Außenring zu berücksichtigen.

Es ist darauf hinzuweisen, dass die Festlegung der Startgeometrie entweder durch Generierung einer der zu erzielenden Zielverzahnung angepassten Geometrie, die sowohl Zahnkopf und Zahnfußbereich umfasst, oder vorzugsweise mathematische Beschreibung eines vollständigen Außenrings erfolgen kann. Ausreichend ist für die Festlegung der Startgeometrie bereits die vollständige Beschreibung mindestens einer halben Zahnperiode der Außenverzahnung. Die jeweilige Verzahnung am Außenring ist entlang des Umfangs des Rings wiederkehrend, wobei eine Zahnperiode jeweils aus einem Zahn und einer Zahnlücke besteht. Sowohl Zahn als auch Zahnlücke sind in sich symmetrisch, so dass die vollständige Zahnringgeometrie durch die Angabe eines Kurvenverlaufs innerhalb einer halben Zahnperiode beschrieben ist. Durch Spiegelung dieses Kurvenverlaufs kann die Zahnperiode vervollständigt werden, die nachfolgend mehrfach am Umfang des Zahnrings wiederholt wird.

Die festzulegende Startgeometrie umfasst auch die erforderlichen Daten zur Bestimmung des Radius des Zahnrings, wobei die geometrischen Zusammenhänge dem Fachmann hinlänglich bekannt sind und daher nicht detailliert beschrieben werden müssen. Nachdem die zuvor genannten Ausgangswerte festgelegt sind, wird mit der Startgeometrie des ersten Rings eine Bewegung nach folgender grundlegender Bewegungsbedingung ausgeführt: Der erste Zahnring (Außenring) bzw. ein die Startgeometrie beschreibender Hüllkurvenabschnitt vollzieht eine Drehbewegung um seine eigene (erste) Drehachse; gleichzeitig eine Umlaufbewegung um die Drehachse des noch nicht definierten zweiten Zahnrings (Innenring), deren Lage zur ersten Drehachse durch die zuvor festgelegte Exzentrizität (Abstand der beiden Drehachsen A, B voneinander) bestimmt ist. Während dieser Doppelbewegung ist kontinuierlich folgende Winkelbeziehung einzuhalten:

$$b = a \times Z$$

wobei

  a = Rotationswinkel des ersten Zahnrings (Außenring)
  b = Rotationswinkel der Exzentrizität
  Z = Zähnezahl am ersten Zahnring (Außenring)

Wurde die Startgeometrie der Innenverzahnung des Außenrings festgelegt, so erfolgt eine Drehbewegung des Außenrings um einen bestimmten Rotationswinkel relativ zu dem Innenring, dessen Zahngeometrie zunächst noch nicht bekannt ist. Zum leichteren Verständnis sei darauf hingewiesen, dass im einfachsten Fall eine vollständige Umlaufbewegung des Außenrings um den Innenring ausgeführt wird, währenddessen der von der Startgeometrie vollzogene Verlauf aufgezeichnet wird. Der Bahnverlauf der Hüllkurvenschnitte der Startgeometrie stellt dabei die gegenüberliegende Zahnform der Außenverzahnung des Innenrings dar. Die Hüllkurve der Startgeometrie stellt dabei die Summe aller Hüllkurvenschnitte im vorgegebenen minimalen Bewegungsbereich dar.

Bei genauerer Betrachtung muss die Umlaufbewegung jedoch nicht notwendigerweise um eine vollständige Umdrehung ausgeführt werden, da für die Bestimmung der resultierenden Zahnformkontur des zweiten Zahnrings (hier der Innenring) ebenfalls ausreichend ist, wenn mindestens eine halbe Periode der Abfolge Zahn-Zahnlücke beschrieben ist. Die Umlaufbewegung des ersten Zahnrings muss daher mindestens um einen Rotationswinkel b vollzogen werden, der einer halben Zahnperiode des dem ersten Zahnring gegenüberliegenden zweiten Zahnrings entspricht. Dieser Rotationswinkel b unter Einhaltung der beschriebenen Bildungsbedingung generiert automatisch die Zähnezahl des Innenrings, die grundsätzlich um eins kleiner als die Zähnezahl des Außenrings ist, sodass sich der mindestens anzuwendende minimale Rotationswinkel leicht bestimmen lässt.

Nach dem Durchführen der erläuterten Doppelbewegung liegen die anfänglich festgelegte Startgeometrie des ersten Zahnrings sowie eine erste generierte und dabei aufgezeichnete Zahnformkontur und damit eine grundsätzlich mögliche Geometrie des zweiten Zahnrings vor. Im Regelfall wird das ebenfalls festgesetzte Gütekriterium nach dem ersten Schritt noch nicht erreicht sein. Erfindungsgemäß wird daher die Startgeometrie des ersten Zahnrings in mindestens einem Parameter in eine (zunächst beliebige) Richtung verändert. Vorzugsweise können für die Veränderung Grenzbedingungen vorgegeben werden und/oder Verhältnisse für sinnvolle Änderungen zugrunde gelegt werden. Beispielsweise kann die Breite des Zahns des ersten Zahnrings um 10% verändert werden, um die Startgeometrie für den nächsten Verfahrensschritt anzupassen. Alternativ oder kumulativ zur Änderung der Startgeometrie des ersten Zahnrings kann auch die Exzentrizität zwischen den Drehachsen der beiden Zahnringe verändert werden, was ebenfalls Auswirkungen auf die sich ergebende Zahnformkontur hat. Vorteilhafterweise wird hier jedoch von einem Fixwert der Exzentrizität ausgegangen. Der angestrebte Zielwert ist dabei eine funktional optimierte Zahnform bei gleichzeitig minimalem Teilkreis und evtl. maximaler Zähnezahl.

Im nächsten Verfahrensschritt wird unter Zugrundelegung der veränderten Ausgangsbedingungen erneut die Doppelbewegung des ersten Zahnrings um den zweiten Zahnring und um seine eigene Drehachse ausgeführt, unter Einhaltung der Bewegungs- bzw. Winkelbedingung, wie dies zuvor beschrieben wurde. Es entsteht eine zweite Zahnformkontur, die von der aus den vorangegangenen Schritten gewonnen ersten Zahnformkontur abweicht, so dass nachfolgend eine Prüfung vorgenommen werden kann, welche der beiden ermittelten Zahnformkonturen das definierte Gütekriterium besser erfüllt. Schließlich können die vorgenannten Schritte iterativ wiederholt werden, um die Zahnformkonturen einem angestrebten Optimum in Bezug auf das Gütekriterium anzunähern.

Im Ergebnis der zuvor beschriebenen Erzeugung bzw. Optimierung von Zahnformen am Innen- und Außenring einer Zahnringmaschine liegen im Regelfall Zahnformkonturen bzw. -geometrien vor, die sich nur noch durch Splines höherer Ordnung (zum Beispiel 3. Ordnung) darstellen lassen. Zwar kann mit dem beschriebenen Verfahren im einfachsten Fall auch annähernd eine Zahnform erzeugt werden, wie sie durch herkömmliche Verfahren ebenfalls erreichbar ist, jedoch können abweichend vom Stand der Technik nunmehr auch Zahnformen erzeugt werden, die für verschiedene Anwendungen leicht zu optimieren sind, obwohl sie mit herkömmlichen Methoden nicht mehr darstellbar sind. Mit Hilfe der genannten Splines können die Konturen weiterhin mathematisch beschrieben werden, so dass sie sich in verfügbaren Datenverarbeitungsprogrammen verwenden lassen, insbesondere zur weiteren Optimierung und zur Ansteuerung von Werkzeugmaschinen.

Ein Vorteil des erfindungsgemäßen Verfahrens besteht somit darin, dass im Gegensatz zur klassischen Verwendung von Rollkurven (Zykloiden) zur Beschreibung der Zahnformen, die sich zur Erzeugung der Zykloide am Teilkreis der Verzahnung abrollen und die eine Seite einer Verzahnungskontur bilden, keine zwingende Kopplung zum Teilkreis als formerzeugende Bedingung vorausgesetzt wird.

Da durch das erfindungsgemäße Verfahren in jedem Durchlauf ausgehend von einer vorgegebenen Startgeometrie eines ersten Zahnrings die vollständige Zahnformkontur des Innen- und des Außenrings erzeugt wird, können die entstehenden Zahnformkonturen oder -geometrien einerseits und das Abroll- bzw. Gleitverhalten der Verzahnung beider Zahnringe andererseits einer Bewertung, d. h. einem Vergleich mit einem Gütekriterium unterzogen werden. Bei geeigneter Wahl der Gütekriterien können auf diese Weise auch Gerotorverzahnungen mit relativ großen Exzentrizitätswerten erzeugt werden. Dabei stellt das Einhalten der oben erläuterten Bewegungsbedingung einen harmonischen Bewegungsablauf zwischen Innen- und Außenverzahnung sowie einen kinematisch harmonischen Lauf bei hoher Effizienz sicher.

Speziell bei der Verwendung der Zahnringmaschine als Zahnringpumpe ermöglicht das erfindungsgemäße Verfahren die Dimensionierung mit großen Exzentrizitäten, wodurch sich strömungsoptimierte Förderkammern ausbilden lassen, die eine Verbesserung der Förderleistung bei höheren Drehzahlen bewirken. Das Verfahren ist grundsätzlich für unterschiedlichste Zahnformen, Zähnezahlen, Exzentrizitäten und Teilkreisradien einsetzbar. Vorteilhaft ist weiterhin, dass keine speziellen Maßnahmen getroffen werden müssen, um die Enden einzelner Kurvenabschnitte, die gewöhnlich für die Beschreibung der Zahnform eingesetzt werden, in ihrem Übergangsverhalten an mathematische Voraussetzungen der genutzten Beschreibung anzupassen. Vielmehr ergeben sich die Kurvenverläufe vollständig aufgrund des erläuterten Ablaufs bei der Optimierung der Zahnform. Die mathematische Beschreibung der resultierenden Geometrie erfolgt durch Splines höherer Ordnung, wobei üblicherweise bereits mit Splines 3. Ordnung eine für die praktischen Anforderungen hinreichende Genauigkeit erzielbar ist.

Gemäß einer bevorzugten Ausführungsform lassen sich mehrere Gütekriterien festlegen, deren Erfüllung bei der Bewertung mehrerer generierter Zahnformkonturen parallel geprüft wird. Beispielsweise kann neben einem zu fördernden Mindestvolumen auch eine Vorgabe für einzuhaltende Kräfteverhältnisse zwischen den Zahnflanken der sich gegenüberstehenden Zähne bestimmt werden. Auf diese Weise besteht die Möglichkeit, die Hertzsche Pressung beispielsweise durch Vergrößerung der lokalen Kontaktradien (Bögen) zu reduzieren.

Weiterhin ist es vorteilhaft, wenn bereits bei der Festlegung der Startgeometrie eines ersten Zahnrings die Beschreibung der Zahnkontur nicht wie im Stand der Technik mit Kreisbögen, Ellipsen oder Segmenten von Winkelfunktionen und Evolventen erfolgt, sondern stattdessen die Startgeometrie durch einen veränderbaren Spline, vorzugsweise 3. Ordnung bestimmt wird. Mit gängiger Software (z.B. Inventor, Catia, Pro-E und UG) lassen sich derartige Splines beschreiben und durch die oben beschriebenen Optimierungsschleifen zielgerichtet variieren. Weitere Vorteile, Ausführungsformen und Einzelheiten ergeben sich aus der nachfolgenden Beschreibung einer bevorzugten Vorgehensweise zur Durchführung des erfindungsgemäßen Verfahrens, unter Bezugnahme auf die Zeichnung. Es zeigen:

Fig. 1     einen Ablaufplan wesentlicher Schritte zur Ausführung des erfindungsgemäßen Verfahrens gemäß einer ersten Ausführungsform;

Fig. 2     eine schematische Darstellung einer Zahnringmaschine mit einem außenverzahnten Innenring und einem innenverzahnten Außenring sowie kenntlich gemachten geometrischen Parametern;

Fig. 3     eine Detaildarstellung eines Zahns des Innenrings während eines Bewegungsabschnitts durch eine Zahnlücke des Außenrings;

Fig. 4     eine schematische Darstellung des Bewegungsablauf zur Erzeugung der Zahnformkontur in einem ersten Zeitpunkt am Beginn der Bewegung

Fig. 5     eine schematische Darstellung des Bewegungsablaufs zur Erzeugung der Zahnformkontur in einem zweiten Zeitpunkt am Ende der Bewegung.

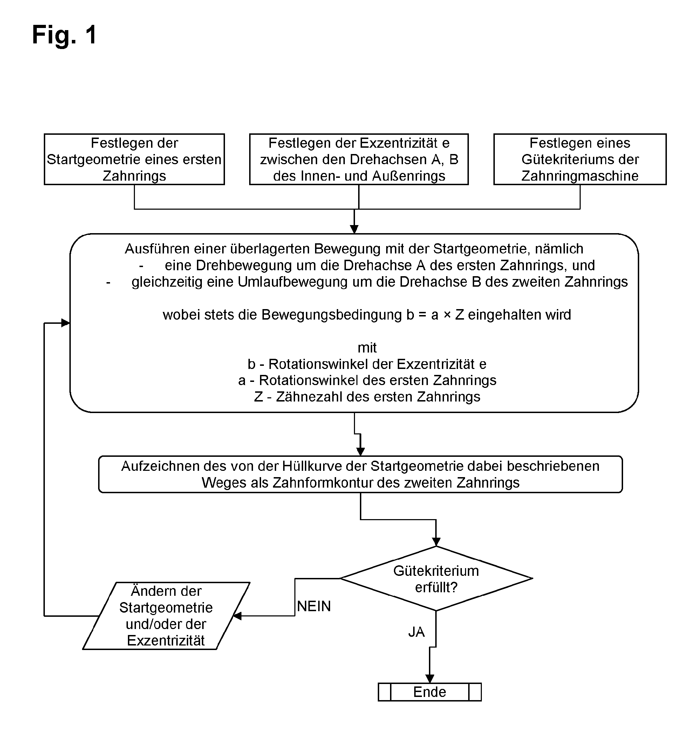

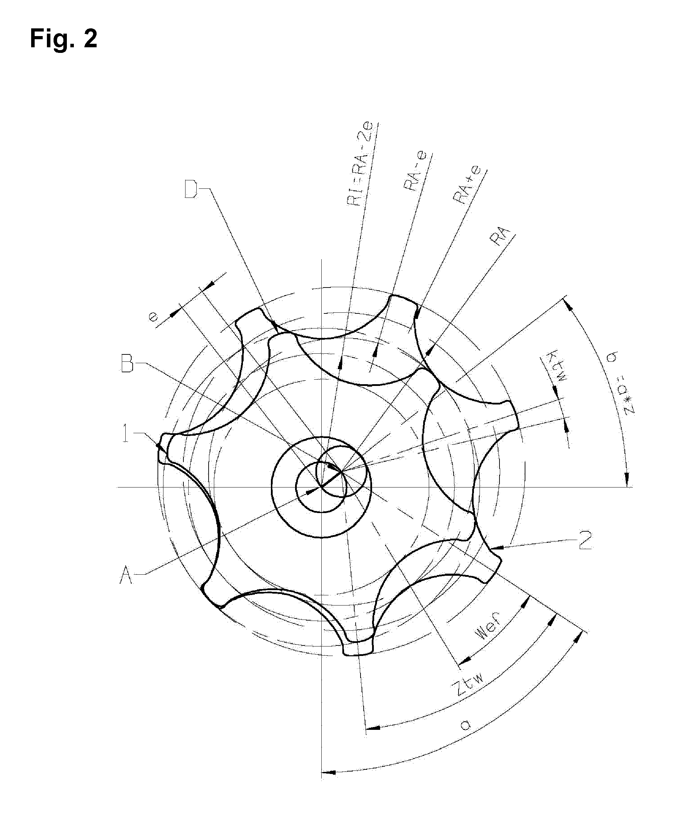

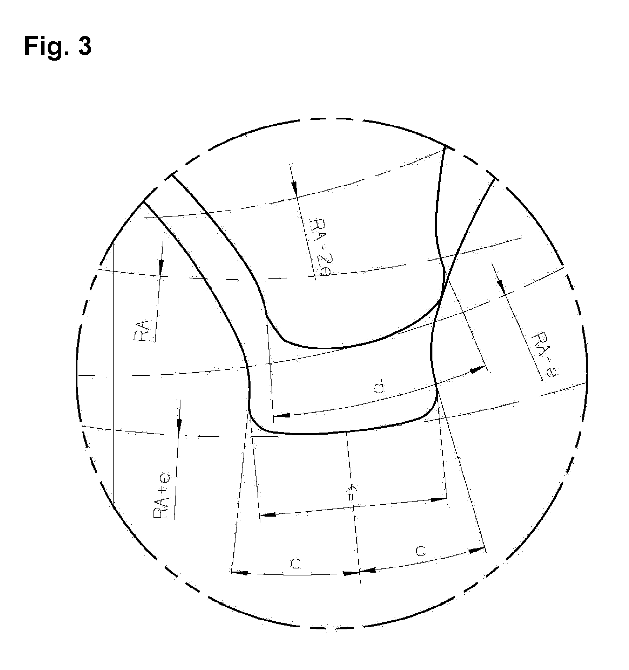

Die nachfolgende Beschreibung wesentlicher und bevorzugter Schritte des erfindungsgemäßen Verfahrens erfolgt unter Bezugnahme auf Fig. 1, in welcher der Verfahrensablauf zusammengefasst ist, sowie gleichzeitiger Bezugnahme auf die Fig. 2 und 3, in denen wichtige geometrische Einzelheiten der Zähne einer Zahnringmaschine eingezeichnet sind.

Grundsätzlich wird durch das erfindungsgemäße Verfahren die Erzeugung von Zahnformen einer Zahnringmaschine angestrebt, wobei die Zahnringmaschine einen Innenring 1 mit einer Außenverzahnung sowie einen Außenring 2 mit einer Innenverzahnung als Hauptelemente aufweist. Bei einer typischen Anwendung kann der Innenring auf einer Abtriebswelle eines Antriebsaggregats angebracht sein, während der Außenring 2 in einem Gehäuse drehbar gelagert ist (nicht dargestellt). Im Betrieb rotiert der Innenring 1 um eine erste Drehachse A, während der Außenring 2 um eine zweite Drehachse B drehbar ist. Die Drehachsen A, B sind um den Betrag einer Exzentrizität e zueinander versetzt bzw. beabstandet. Außerdem bewegt sich beim Betrieb der Zahnringmaschine der Außenring 2 in einer Umlaufbewegung um die erste Drehachse A, d.h. die Exzentrizität e rotiert um den Drehpunkt, durch welchen die erste Drehachse A verläuft. In Fig. 3 ist die typische Zahnformkontur eines einzelnen Zahns des Innenrings 1 sowie einer komplementären Zahnlücke des Außenrings 2 in vergrößerter Detaildarstellung erkennbar. Dort sind auch die geometrischen Bedingungen eingezeichnet, die für die Definition der Startgeometrie benötigt werden. In der Fig. 3 ist die maximale Erhebung des Zahns bei $R_A$+e sowie die minimale Tiefe der Zahnlücke bei $R_A$-e eingezeichnet. Schließlich können noch die maximale Zahnkopfbreite sowie eine gegebenenfalls taillierte Zahnkopfbreite im Falle eingeschnürter Zähne für die Festlegung der Startgeometrie von Bedeutung sein. Auf die einzelnen geometrischen Merkmale der Zahnformkontur wird weiter unten noch eingegangen.

Der Teilkreis des Innenrings generiert sich automatisch durch die funktionalen Zusammenhänge die sich aus dem Teilkreis des Außenrings ableiten nach folgender Gesetzmäßigkeit:

$$R_i = R_A - 2e$$

wobei

$R_A$ = Teilkreis des Außenrings
$R_i$ = Teilkreis des Innenrings
e = Exzentrizität zwischen den Drehachsen

Zur Beschreibung der Startgeometrie sind außerdem folgende Zusammenhänge bedeutsam:

$$Z_{tw} = 360°/Z$$

wobei

$Z_{tw}$ = Zahnteilungswinkel am Außenring

$$K_{tw} = Z_{tw} \bullet g$$

wobei

$K_{tw}$ = Zahnfußteilungswinkel am Außenring
g = Zahnteilung/Fußbreitenverhältnis, vorzugsweise 0,08 bis 0,13

$$W_{ef} = 0,5 Z_{tw}$$

wobei
$W_{ef}$ = Erzeugungsflankenwinkel

$$E_{fv} = W_{ef}/K_{tw} = h$$

wobei

E$_{fv}$ = Erzeugungsflankenwinkelverhältnis

h = Kopfbreiten/Fußbreitenverhältnis vorzugsweise 3 bis 5,5

Bei dem in Fig. 3 dargestellten Beispiel wurde ein keulenförmiger Zahn am Innenring erzeugt. Die Keulenform kann durch den Keulenwinkel d definiert werden. Ein dargestellter abgeflachter Geometriebereich am Zahn des Innenrings stellt das Resultat einer Zahngeometrieoptimierung dar. Dieser Bereich dient der partiellen Absenkung der Hertzschen Pressung im Kontaktbereich zur Verzahnung am Außenring. Dieser Bereich wird erfahrungsgemäß bei Einleitung des Drehmomentes hoch belastet und kann bei zu hohen Hertzschen Pressungen zu möglichem Verschleiß führen.

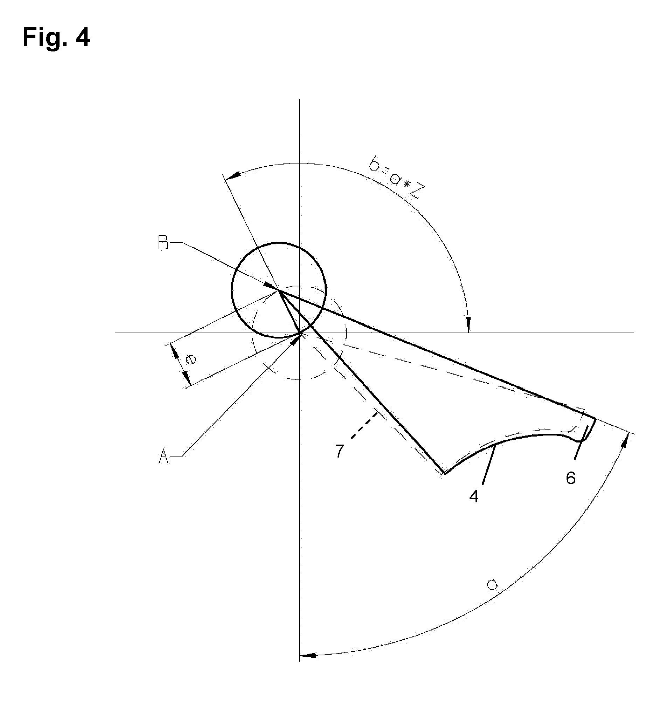

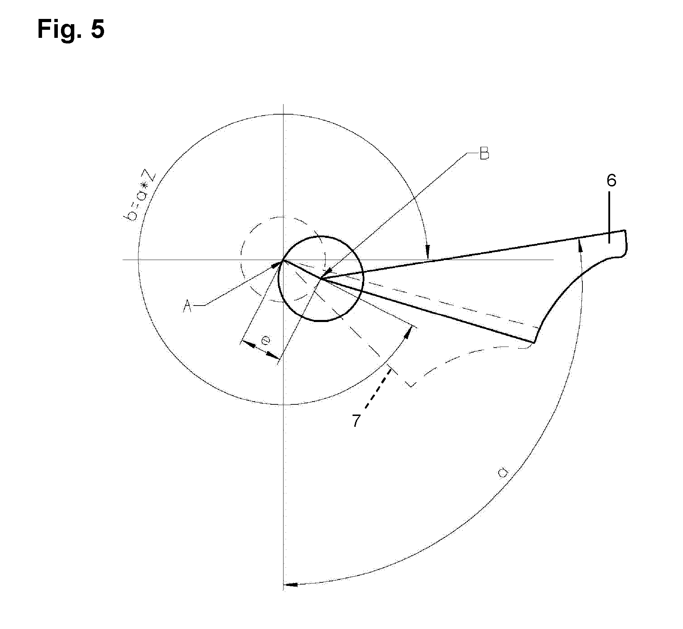

Die Fig. 4 und 5 zeigen beispielhaft zwei Abschnitte bei der Erzeugung einer Zahnform. Für die Ausführung des erfindungsgemäßen Verfahrens wird im ersten Schritt eine Startgeometrie eines ersten Zahnrings festgelegt. Als erster Zahnring kann der Außenring bestimmt werden. Die Startgeometrie lässt sich vollständig definieren durch Beschreibung einer halben Zahnperiode. In Fig. 4 ist beispielhaft ein Abschnitt des Außenrings 2, bestehend aus einem halben Zahn und einer halben Zahnlücke als Außenringkontur 6 (Volllinie) dargestellt. Vorzugsweise wird dieser Abschnitt der Startgeometrie durch einen Spline 4 dritter Ordnung mit beispielsweise acht Stützpunkten definiert. Der die Startgeometrie beschreibende Spline 4 wird durch zwei radial verlaufende Winkellinien (oder Teilungsbegrenzungslinien) eingeschlossen, die eine halbe Zahnperiode voneinander beabstandet verlaufen. Der zwischen den Winkellinien eingeschlossene Winkel W$_{ef}$ (Fig. 2) wird als Erzeugungsflankenwinkel bezeichnet. Der Spline 4 verläuft an seinen beiden Enden senkrecht zu den Winkellinien. In radialer Richtung wird der Spline 4 durch den Zusammenhang zwischen Teilkreis des Außenrings R$_A$ und Exzentrizität e begrenzt (Fig. 3). Am gegenüberliegenden Innenring soll durch die Bewegung eine Innenringkontur 7 erzeugt werden, deren erst noch entstehende Formgebung gestrichelt dargestellt ist.

Neben der Startgeometrie muss am Beginn des Verfahrens noch die Exzentrizität e zwischen der Drehachse A des Innenrings 1 und der Drehachse B des Außenrings 2, sowie mindestens ein Gütekriterium als Randbedingung, welche die zu erzeugende Zahnringmaschine erfüllen soll, festgelegt werden.

Wie oben bereits allgemein erläutert wurde, wird im nächsten Verfahrensschritt eine Drehbewegung der vordefinierten Startgeometrie 6 des Außenrings 2 um seine eigene Drehachse B sowie gleichzeitig eine Umlaufbewegung um die Drehachse A des zu formenden Innenrings 1 ausgeführt. Während diese Doppelbewegung muss erfindungsgemäß die folgende allgemeine Bewegungsbedingung eingehalten werden:

$$b = a \times Z$$

wobei im hier beschriebenen Beispiel

a = Rotationswinkel des Außenrings

b = Rotationswinkel der Exzentrizität

Z = Zähnezahl am Außenring

Für die vollständige Beschreibung der Zahnkontur am zweiten Zahnring ist es grundsätzlich ausreichend, wenn die relative Drehbewegung über mindestens eine halbe Zahnperiode des zweiten Zahnrings ausgeführt wird, so dass die zuvor festgelegte Startgeometrie, d. h. die Hüllkurve, welche mindestens eine halbe Zahnperiode am vordefinierten ersten Zahnring beschreibt, entlang einer Bahn bewegt wird, welche die Zahnkontur des gegenüberliegenden zweiten Zahnrings beschreibt.

Fig. 5 zeigt die Situation zu einem späteren Zeitpunkt nach Ausführen der Doppelbewegung. Die Exzentrizität e und mit ihr die Außenringkontur 6 wurde hier um einen Rotationswinkel b = 707° um die Drehachse A gegenüber der in Fig. 4 gezeigten Stellung weiter verschwenkt. Währenddessen hat sich der Rotationswinkel a von 68° (bei b = 476°) auf 101° verändert. Bei einer Zähnezahl des Außenrings von Z = 7, wurde die genannte Bewegungsbedingung somit eingehalten. Die Innenringkontur 7 ist in dem in Fig. 5 gezeigten Zustand fast vollständig beschrieben, d.h. die Erzeugungsbewegung ist beinahe abgeschlossen.

Nachdem durch das Ausführen der Doppelbewegung die Zahnformkontur des zweiten Zahnrings generiert und aufgezeichnet wurde, kann eine erste Überprüfung vorgenommen werden, ob die damit vorliegenden Zahnformkonturen beider Zahnringe bereits das zuvor festgelegte Gütekriterium erfüllen oder ob die Zahnformen angepasst werden müssen. Wenn das Gütekriterium noch nicht erfüllt ist, was nach dem ersten Durchlauf regelmäßig der Fall sein wird, wird die Startgeometrie und/oder die anfangs festgelegte Exzentrizität um einen vorbestimmten Wert verändert, vorzugsweise in einer vorgegebenen Richtung, die eine Verbesserung der Geometrie erwarten lässt. Diese Werteänderung kann automatisch unter vorbestimmten Grenzbedingungen erfolgen oder manuell vom Benutzer vorgegeben werden, der an dieser Stelle zur Dateneingabe aufgefordert werden kann. Der Benutzer kann über die Änderung der Startgeometrie seine Erfahrungen in der Dimensionierung einfließen lassen, wenngleich dies für den automatischen Ablauf des Verfahrens nicht notwendig ist. Mit den veränderten Ausgangswerten wird die Drehbewegung dann erneut ausgeführt, um eine zweite Zahnformkontur des zweiten Zahnrings aufzuzeichnen. Diese Wiederholungsschleife kann mehrfach ausgeführt werden, vorzugsweise unter Durchführung iterativer Schritte. Sobald die festgelegten Gütekriterien erfüllt sind, kann das Verfahren beendet werden und die zuletzt festgesetzten bzw. aufgezeichneten Zahnformkonturen der beiden Zahnringe stellen damit das Ergebnis des Erzeugungsverfahrens dar.

Durch die Anwendung der oben genannten Bewegungsbedingung wird eine im Vergleich zu im Stand der Technik verwendeten Bewegungsgleichungen sehr einfache Nachbildung des Bewegungsablaufes und damit eine einfache Erzeugungsmethode für die Zahngeometrien bereitgestellt. Dabei wird in jedem Fall eine geschlossene Hüllkurve zur Beschreibung der Zahnform am zweiten Zahnring erzeugt, welche die Kontur der Zahngeometrie der dort anzuordnenden Zähne bei zwingender Einhaltung der Bewegungsbedingung am Außenring darstellt. Durch die Einbeziehung des Teilkreisdurchmessers $R_A$ des Außenrings in die möglichen Variablen, die während mehrere Durchläufe des Verfahrens veränderbar sind, und die computerunterstützte Simulation/ Modellierung der Bewegungsbedingung der Außenringkontur ist es in wenigen Iterationsschritten möglich, eine optimale Geometrie für die Innenring-Zahnkontur zu finden, die sich nachfolgend durch Splines darstellen lässt.

**Bezugszeichenliste**

1　　- Innenring
2　　- Außenring
3　　-
4　　- Spline
5　　-
6　　- Außenringkontur
7　　- Innenringkontur

A　　　- Drehachse des Innenrings
B　　　- Drehachse des Außenrings
e　　　- Exzentrizität
$W_{ef}$　- Erzeugungsflankenwinkel
a　　　- Rotationswinkel des ersten Zahnrings (Außenrings)
b　　　- Rotationswinkel der Exzentrizität e
Z　　　- Zähnezahl am ersten Zahnring (Außenring)
$R_A$　- Teilkreis Außenring
$R_i$　- Teilkreis des Innenrings
$Z_{tw}$　- Zahnteilungswinkel am Außenring
$E_{fv}$　- Erzeugungsflankenwinkelverhältnis
$K_{tw}$　- Zahnfußteilungswinkel am Außenring
g　　　- Zahnteilung/Fußbreitenverhältnis
h　　　- Kopfbreiten/Fußbreitenverhältnis
d　　　- Keulenwinkel

**Patentansprüche**

1.　Verfahren zur Erzeugung der Zahnform eines ersten und eines zweiten Zahnrings einer Zahnringmaschine, folgende Schritte umfassend:

　　a) Festlegung einer Startgeometrie des ersten Zahnrings, der ein Außenring (2) der Zahnringmaschine ist, mindestens eines Gütekriteriums der Zahnringmaschine sowie einer gewünschten Exzentrizität (e) zwischen den Drehachsen (A, B) der beiden Zahnringe, wobei die Startgeometrie durch Splines höherer Ordnung beschrieben wird;
　　b) Ausführen einer Bewegung mit der festgelegten Startgeometrie, wobei die Startgeometrie eine Drehbewegung um die eigene Drehachse (B) und gleichzeitig eine Umlaufbewegung um die Drehachse (A) des zweiten Zahnrings ausführt, und wobei diese Drehbewegung und diese Umlaufbewegung so miteinander verkoppelt sind, dass der Rotationswinkel (b) der Exzentrizität (e) kontinuierlich gleich dem Produkt aus dem Rotationswinkel (a) des ersten Zahnrings und der Zähnezahl (Z) des ersten Zahnrings ist (b = a $\times$ Z);
　　c) Generieren der Zahnformkontur des zweiten Zahnrings durch Aufzeichnen des von der Hüllkurve der Startgeometrie beim Ausführen der Bewegung nach Schritt b) beschriebenen Weges, wobei die aufgezeichnete Zahnformkontur durch Splines höherer Ordnung beschrieben wird;
　　d) Prüfung, ob mit der Startgeometrie und der aufgezeichneten Zahnformkontur das festgelegte Gütekriterium erfüllt wird;
　　e) sofern das Gütekriterium noch nicht erfüllt ist, Veränderung der zuvor verwendeten Startgeometrie und/oder der festgelegten Exzentrizität (e);
　　f) iteratives Wiederholen der Schritte b) bis e) und Generieren einer veränderten Zahnformkontur bis zur Erfüllung des Gütekriteriums.

2.　Verfahren nach Anspruch 1, wobei als Startgeometrie mindestens eine halbe Zahnperiode der Außenverzahnung festgelegt wird.

3.　Verfahren nach Anspruch 1 oder 2, wobei das Ausführen der relativen Drehbewegung zwischen Innen- und Außenring rechnergestützt unter Verwendung eines mathematischen Modells von Innen- und Außenring durchgeführt wird.

4.　Verfahren nach einem der Ansprüche 1 bis 3, wobei die iterative Wiederholung der Schritte b) bis e) unabhängig von der Erfüllung des Gütekriteriums abgebrochen wird, wenn ein zuvor bestimmtes Abbruchkriterium erfüllt ist.

5.　Verfahren nach einem der Ansprüche 1 bis 4, wobei die Umlaufbewegung im Schritt b) um einen Rotationswinkel (b) der Exzentrizität (e) ausgeführt wird, der mindestens eine halbe Zahnperiode des zweiten Zahnrings überdeckt.

6. Zahnring einer Zahnringmaschine, **dadurch gekennzeichnet, dass** die Zahnform seiner Verzahnung nach einem Verfahren gemäß einem der Ansprüche 1 bis 5 hergestellt wurde.

**Claims**

1. Method for forming the tooth shape of a first and a second annular gear of an annular gear machine, comprising the following steps:

    a) establishing a starting geometry of the first annular gear, being an outer ring (2) of the annular gear machine, at least one quality criterion of the annular gear machine as well as a desired eccentricity (e) between the rotation axes (A, B) of the two annular gears, wherein the starting geometry is described by high-order splines;
    b) performing a movement with the starting geometry established, wherein the starting geometry performs a rotational movement about its own rotational axis (B) and at the same time a revolving movement about the rotational axis (A) of the second annular gear, and wherein this rotational movement and this revolving movement are interrelated such that the angle of rotation (b) of the eccentricity (e) is continuously equal to the product of the angle of rotation (a) of the first annular gear and the number of teeth (Z) of the first annular gear (b = a × Z);
    c) generating the tooth shape contour of the second annular gear by plotting the path described by the envelope curve of the starting geometry when performing the movement according to step b), wherein the plotted tooth shape contour is described by high-order splines;
    d) checking for the quality criterion to be fulfilled with the starting geometry and the plotted tooth shape contour;
    e) if the quality criterion is not yet fulfilled, varying the previously used starting geometry and/or the established eccentricity (e);
    f) iterative repeating of steps b) to e) and generating a different tooth shape contour until the quality criterion is fulfilled.

2. Method according to claim 1, wherein at least one half-tooth period of the outer toothing is specified as the starting geometry.

3. Method according to claim 1 or 2, wherein the execution of the relative rotary movement between inner and outer ring is done by computer assistance, using a mathematical model of the inner and outer ring.

4. Method according to one of claims 1 to 3, wherein the iterative repetition of steps b) to e) is broken off regardless of fulfilling the quality criterion when a previously determined termination criterion is fulfilled.

5. Method according to one of claims 1 to 4, wherein the revolving movement in step b) is executed by an angle of rotation (b) of the eccentricity (e) that spans at least one half-tooth period of the second annular gear.

6. Annular gear of an annular gear machine, **characterized in that** the tooth shape of its toothing has been produced by a method according to one of claims 1 to 5.

**Revendications**

1. Procédé de création de la forme de dent d'une première et d'une seconde couronne dentée d'une machine à couronnes dentées, comprenant les étapes suivantes :

    a) détermination d'une géométrie de départ de la première couronne dentée, qui est une cou
    b) ronne extérieure (2) de la machine à couronnes dentées, au moins d'un critère de qualité de la machine à couronnes dentées ainsi que d'une excentricité (e) souhaitée entre les axes de rotation (A, B) des deux couronnes dentées, sachant que la géométrie de départ est décrite par des splines d'ordre supérieur ;
    b) exécution d'un mouvement avec la géométrie de départ déterminée, sachant que la géométrie de départ effectue une rotation sur son propre axe de rotation (B) et parallèlement un tour sur l'axe de rotation (A) de la seconde couronne dentée, et sachant que cette rotation et ce tour sont ainsi couplés entre eux, que l'angle de rotation (b) de l'excentricité (e) est continuellement égal au produit de l'angle de rotation (a) de la première couronne dentée et du nombre de dents (Z) de la première couronne dentée, soit (b = a x Z) ;
    c) génération du contour de la forme de dent de la seconde couronne dentée par l'enregistrement du trajet décrit par la courbe d'enveloppe de la géométrie de départ lors de l'exécution du mouvement selon l'étape b), sachant que le contour de forme de dent enregistré est décrit par des splines d'ordre supérieur ;
    d) vérification si avec la géométrie de départ et le contour de la forme de dent enregistré, le critère de qualité déterminé est rempli ;
    e) dans la mesure où le critère de qualité n'est pas encore rempli, modification de la géométrie de départ employée auparavant et/ou de l'excentricité (e) déterminée ;

f) répétition itérative des étapes b) à e) et génération d'un contour de la forme de dent modifié jusqu'à ce que le critère de qualité soit rempli.

2. Procédé selon la revendication 1, dans lequel au moins une demi-période de dent de la denture extérieure est déterminée en tant que géométrie de départ.

3. Procédé selon la revendication 1 ou 2, dans lequel l'exécution de la rotation relative entre la couronne intérieure et extérieure est assistée par ordinateur en employant un modèle mathématique de la couronne intérieure et extérieure.

4. Procédé selon l'une des revendications 1 à 3, dans lequel la répétition itérative des étapes b) à e) est interrompue indépendamment du fait si le critère de qualité est rempli, lorsqu'un critère d'interruption défini au préalable est rempli.

5. Procédé selon l'une des revendications 1 à 4, dans lequel le tour de l'étape b) est effectué dans un angle de rotation (b) de l'excentricité (e) qui recouvre au moins une demi-période de dent de la seconde couronne dentée.

6. Couronne dentée d'une machine à couronnes dentées, **caractérisée en ce que** la forme de dent de sa denture est fabriquée selon un procédé selon l'une des revendications 1 à 5.

# Fig. 1

**Fig. 2**

# Fig. 3

# Fig. 4

# Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3709055 A
- US 2960884 A
- JP 10205458 A
- EP 1340913 B1
- DE 10208408 A1
- US 5030072 A
- DE 3026222 A1
- US 2666336 A
- EP 1462653 A1

**In der Beschreibung aufgeführte Nicht-Patentliteratur**

- **SHIH-HSI TONG.** Design of deviatation-function based gerotors. *Mechanism and Machine Theory,* 2009, vol. 44, 1595-1606